# EUROPÄISCHE PATENTSCHRIFT

(11) **EP 2 918 702 B1**
(45) Veröffentlichungstag und Bekanntmachung des Hinweises auf die Patenterteilung: **01.05.2019**
(21) Anmeldenummer: 15158596.5
(22) Anmeldetag: 11.03.2015
(51) Int. Cl.: C23C 16/458, C30B 25/12

(54) **BESCHICHTETES BAUTEIL EINES CVD-REAKTORS UND VERFAHREN ZU DESSEN HERSTELLUNG**
COATED COMPONENT OF A CVD REACTOR AND METHOD FOR PRODUCING THE SAME
COMPOSANT REVÊTU D'UN RÉACTEUR CVD ET SON PROCÉDÉ DE FABRICATION

(30) Priorität: 14.03.2014 DE 102014103505
(43) Veröffentlichungstag der Anmeldung: 16.09.2015
(73) Patentinhaber: Aixtron SE, 52134 Herzogenrath (DE)
(72) Erfinder: Deufel, Markus, 52072 Aachen (DE); Kessel, Mario Wilhelm Angelo, 4721 Neu-Moresnet (BE); Kollberg, Marcel, 52146 Würselen (DE)
(74) Vertreter: Grundmann, Dirk

(56) Entgegenhaltungen:
- EP-A1- 1 790 757
- JP-A- 2000 248 362
- US-A1- 2007 169 703
- US-A1- 2012 070 577
- US-B1- 6 740 167

## Beschreibung

Die Erfindung betrifft ein Bauteil, insbesondere Suszeptor eines CVD-Reaktors, mit einem Grundkörper, der aus einem ersten Werkstoff gefertigt ist und mit einem zweiten Werkstoff beschichtet ist, wobei der erste Werkstoff verschieden vom zweiten Werkstoff ist.

Die Erfindung betrifft darüber hinaus ein Verfahren zum Fertigen eines derartigen Bauteils, insbesondere eines Suszeptors eines CVD-Reaktors, wobei ein Grundkörper, der aus einem ersten Werkstoff gefertigt ist, an mindestens einer Stelle mit einem Haltewerkzeug gehalten wird und mit einem zweiten Werkstoff, der vom ersten Werkstoff verschieden ist, beschichtet wird.

Die DE 19919 902 A1 beschreibt einen aus Graphit oder ähnlichem bestehenden Waferträger, der Teil eines CVD-Reaktors ist, und der mit einer Beschichtung aus einem Metallkarbid oder einem Metallnitrit versehen ist.

Aus der DE 10 2007 027 704 A1, DE 10 2007 023 970 A1 und DE 102 32 731 A1 sind weitere Teile eines CVD-Reaktors bekannt, die mit einer Schutzschicht beschichtet sind.

Die WO 2007/087196A2 befasst sich mit Problemen, die beim Aufheizen und Abkühlen von Suszeptoren aus Werkstoffen mit verschiedenen Temperaturausdehnungskoeffizienten auftreten können.

Die US 6,740,167 B1 beschreibt einen Suszeptor mit einem Einsatz aus Sintermaterial.

Die US 2005/0022746 A1 beschreibt einen Suszeptor mit einer Rippenstruktur, der oberflächenbeschichtet ist.

Die DE 689 21 501 T2 beschreibt ein Verfahren zur Beschichtung eines Suszeptors unter Verwendung einer Maske, so dass bestimmte Bereiche des Suszeptors nicht beschichtet werden.

Die EP 1 790 757 A1 beschreibt einen Suszeptor eines CVD-Reaktors, der einen Grundkörper aus Graphit besitzt, der mit SiC beschichtet ist. Der beschichtete Grundkörper besitzt eine Öffnung, in die ein Einsatz eingesetzt ist, der aus TaC besteht oder TaC-beschichtet ist.

Die US 2007/0169703 A1 beschreibt einen Suszeptor mit einem Substratträger, der an seiner Unterseite beschichtet ist. Er besitzt dort eine Öffnung, in die ein Einsatzstück eingesetzt ist. Das Einsatzstück bildet zusammen mit dem Grundkörper des Suszeptors eine Schichtenanordnung mit verschiedenen Wärmeausdehnungskoeffizienten.

Der Erfindung liegt die Aufgabe zugrunde, Maßnahmen anzugeben, mit denen sich das Beschichtungsverfahren vereinfachen lässt.

Gelöst wird die Aufgabe durch die in den Ansprüchen angegebene Erfindung. Sie betrifft ein Verfahren gemäß Anspruch 1 zum Beschichten eines Bauteils sowie ein nach dem Verfahren gefertigtes Bauteil gemäß Anspruch 2.

Erfindungsgemäß wird vorgeschlagen, dass das zu beschichtende Bauteil zumindest einen Oberflächenabschnitt aufweist, der von zumindest einem Einsatz gebildet ist, der in einer Ausnehmung eines Grundkörpers aus einem ersten Werkstoff steckt. Der Einsatz besteht aus einem zweiten Werkstoff, mit dem der Grundkörper beschichtet wird. Beispielsweise kann der Grundkörper aus Graphit oder Metall, bspw. Molybdän bestehen. Die Beschichtung, der zweite Werkstoff kann ein Karbid oder ein Nitrit sein. Die Beschichtung hat insbesondere Komponenten aus Ta, Si, Zr, Nb sowie B und N und C. Insbesondere werden TaC, NbC, ZrC, SiC, BN verwendet. Bei dem Bauteil kann es sich um einem Suszeptor handeln, der in einem CVD-Reaktor, insbesondere einem MOCVD-Reaktor als Waferträger verwendet wird. Er besitzt zwei voneinander weg weisende Oberflächen, eine untere Oberfläche, die mittels einer Heizeinrichtung mit Wärme beaufschlagt wird und eine dieser gegenüberliegenden oberen Oberfläche, die eine Vielzahl von Taschen aufweist, in denen jeweils zu beschichtende Wafer einliegen. Der Suszeptor kann eine kreisrunde Umfangskontur aufweisen. Er hat insbesondere eine Kreisscheibenform. Als Bauteile kommen aber auch Bestandteile eines aus mehreren Teilen bestehenden Suszeptors in Betracht, bspw. Einzelwaferträger, die in Ausnehmungen der Oberseite des Suszeptors einliegen, und die unter Zuhilfenahme eines Gaspolsters drehantreibbar sind. Ferner kommen als erfindungsgemäß zu beschichtende oder erfindungsgemäß beschichtete Bauteile Elemente einer Prozesskammerdecke in Betracht, die in einem CVD-Reaktor, insbesondere MOCVD-Reaktor parallel zur Oberseite des Suszeptors verläuft. Als Bauteil kann ferner ein Gaseinlasselement oder Gasauslasselement eines CVD-Reaktors in Betracht kommen. In einem derartigen CVD-Reaktor findet in der Prozesskammer zwischen Suszeptor und Prozesskammerdecke ein Hochtemperatur-CVD-Verfahren unter Verwendung aggressiver Gase, bspw. NH₃, AsH₃, PH₃ und/oder metallorganischer Verbindungen von Elementen der dritten Hauptgruppe statt, bspw. TMGa, TMIn, TMAl. Es werden Schichten, die Gallium, Arsen, Indium, Phosphor und Stickstoff enthalten abgeschieden. Die in Rede stehenden Bauteile finden aber auch Verwendung bei CVD-Beschichtungs-Prozessen, bei denen halogenhaltige, insbesondere chlorhaltige Verbindungen verwendet werden. In einer ersten Variante der Erfindung wird ein Einsatzkörper aus einem zweiten Werkstoff, der identisch ist mit dem Werkstoff der Beschichtung verwendet, der in einer Durchgangsbohrung des zu beschichtenden Bauteiles steckt. Er besitzt zwei freie Oberflächenabschnitte, an denen jeweils ein Haltewerkzeug angreifen kann, um das zu beschichtende Bauteil in einer Beschichtungskammer zu halten, in der ein Beschichtungsprozess insbesondere bei vermindertem Drücken, insbesondere unter Vakuumbedingungen stattfindet. Das Beschichtungsverfahren kann bei Temperaturen zwischen 1000° C bis 2000° C vorgenommen werden. In einer Variante der Erfindung ist vorgesehen, dass mehrere Einsatzkörper in jeweils einer Ausnehmung stecken. Ferner kann vorgesehen sein, dass die Ausnehmungen Sackbohrungen sind, in denen jeweils ein Einsatzkörper steckt. Die Einsatzkörper stecken derart in den ihnen zugeordneten Ausnehmungen, dass mindestens ein Oberflächenabschnitt nach außen frei liegt. Es kann vorgesehen sein, dass der Oberflächenabschnitt zu einem benachbarten Oberflächenabschnitt des zu beschichtenden Grundkörpers bündig liegt. Die Einsatzkörper stecken vorzugsweise passgenau in den ihnen zugeordneten Ausnehmungen. Sie können dort reibschlüssig oder formschlüssig gehalten sein. Eine Formschlussverbindung kann bspw. über einen Gewindeeingriff erzielt werden. Es ist aber auch vorgesehen, dass die freie Oberfläche des Einsatzkörpers beim Beschichten teilweise mitbeschichtet wird. Insbesondere kann vorgesehen sein, dass der gesamte Rand der freien Oberfläche des Einsatzkörpers, der an die Oberfläche des Grundkörpers angrenzt, mitbeschichtet wird. Hierzu greifen die Haltewerkzeuge an vom Rand entfernten Stellen an den freien Oberflächen der Einsatzkörper an. Bei einem flachen zu beschichtenden Bauteil, insbesondere einem kreisscheibenförmigen zu beschichtenden Bauteil können die Ausnehmungen, in denen jeweils ein Einsatz steckt an der Unterseite des Bauteils angeordnet sein, bzw. an der von der Prozesskammer weg weisenden Seite. Es handelt sich dann um Sackbohrungen, in denen die Einsätze stecken. Es ist von Vorteil, wenn die Einsätze eines kreisscheibenförmigen Bauteils auf einer Grundlinie angeordnet sind, die koaxial zum Zentrum des Bauteiles verläuft. Auf dieser Linie können die Einsätze in gleichmäßiger Winkelverteilung, bspw. um 120 Grad versetzt zueinander angeordnet sein. In einer Variante, bei der das Bauteil eine Zylinderform aufweist, können die Ausnehmungen, in denen jeweils ein Einsatzkörper steckt in der Mantelwand des Zylinders angeordnet sein. Auch hier ist eine gleichmäßig winkelverteilte Anordnung von Vorteil. Drei Einsätze reichen in der Regel aus, um das Bauteil mit drei in verschiedenen Richtungen wirkenden Haltewerkzeugen in der Beschichtungskammer zu halten. Ein erfindungsgemäßer Suszeptor kann eine Vielzahl von Substratträgern halten. Bei den Substratträgern handelt es sich um kreisscheibenförmige Körper, die auf der Breitseitenoberfläche des Suszeptors angeordnet sind und um eine Drehachse, die ihrer Konturachse entspricht, drehangetrieben werden können. Die Substratträger werden dabei von einem Gaskissen getragen, welches von einem Gas erzeugt wird, welches aus der Breitenseitenfläche des Suszeptors heraus strömt. Insbesondere besitzt die Breitseitenfläche spiralförmige Kanäle, in deren Böden Gasaustrittsöffnungen münden. Zur Leitung dieses Gases zur Gasaustrittsöffnung besitzt der Suszeptor Gaskanäle, die von Bohrungen ausgebildet sind. Es handelt sich dabei um Sackbohrungen, die von der äußeren Mantelfläche her in Radialeinwärtsrichtung gebohrt werden. Durch Querbohrungen entsteht eine Gaseinspeiseöffnung und mehrere Gasaustrittsöffnungen, die in den Böden der spiralförmigen Nuten angeordnet sind. Die zum Bohren der Sackbohrung erforderliche Öffnung wird von einem Einsatzkörper der zuvor beschriebenen Art verschlossen.

Ausführungsbeispiele der Erfindung werden nachfolgend anhand beigefügter Zeichnungen erläutert. Es zeigen:
- Figur 1:: die Draufsicht auf einen kreisscheibenförmigen Suszeptor, aufweisend eine Vielzahl von Taschen jeweils zur Aufnahme eines Substrates,
- Figur 2:: den Schnitt gemäß der Linie II - II in Figur 1,
- Figur 3:: ein zweites Ausführungsbeispiel der Erfindung ebenfalls in Form eines Suszeptors,
- Figur 4:: den Schnitt gemäß der Linie IV - IV in Figur 3,
- Figur 5:: ein drittes Ausführungsbeispiel der Erfindung ebenfalls in Form eines Suszeptors, jedoch mit Blick auf die Unterseite
- Figur 6:: den Schnitt gemäß der Linie VI - VI in Figur 5.
- Figur 7:: ein viertes Ausführungsbeispiel der Erfindung in Form eines Suszeptors mit von Sackbohrungen gebildeten Gaseinspeisekanälen 8, die jeweils mit einem Einsatzkörper 2 verschlossen sind.

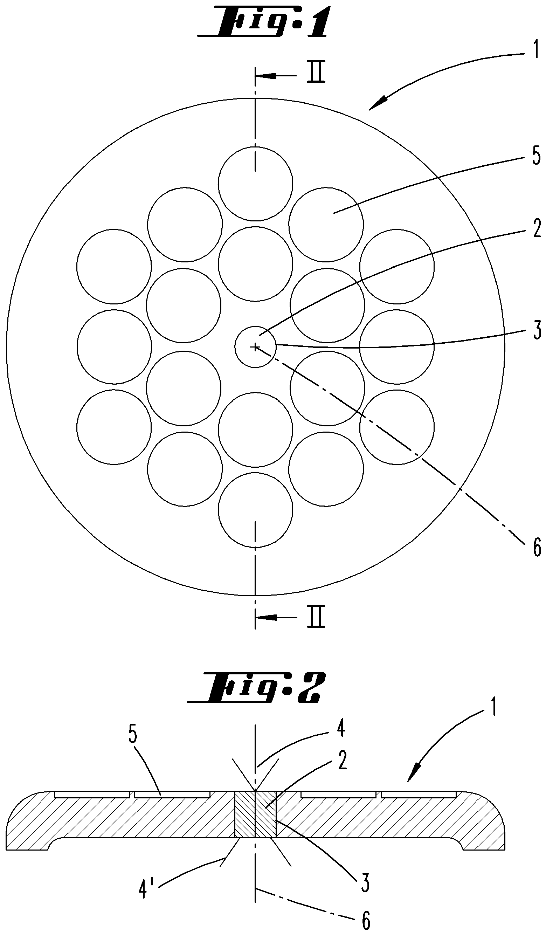

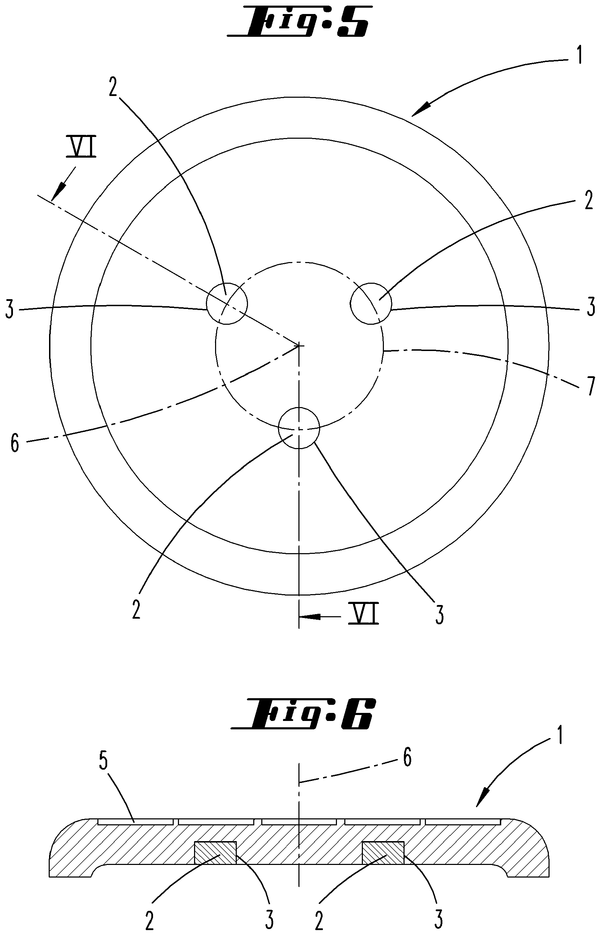

Bei den Ausführungsbeispielen handelt es sich jeweils um einen Suszeptor eines CVD-Reaktors, der einen aus Graphit gefertigten Grundkörper 1 besitzt, der im Wesentlichen die Form einer Kreisscheibe hat. In mindestens einer Aussparung 3 des Grundkörpers 1 steckt ein Einsatzkörper 2. Im Ausführungsbeispiel handelt es sich um einen Einsatzkörper aus Siliziumkarbid (SiC). Die Einsatzkörper 2 sind derart in die ihnen zugeordneten Aussparungen 3 eingesetzt, dass zumindest eine freie Oberfläche des Einsatzkörpers bündig in einen Oberflächenabschnitt des Grundkörpers 1 übergeht. In den Ausführungsbeispielen haben die Einsatzkörper 2 die Gestalt von kreiszylindrischen Körpern. Sie stecken in kreiszylindrischen Ausnehmungen 3, die durch Bohren erzeugt sind. Die freien Oberflächen, bei denen es sich um zumindest eine Stirnfläche des zylinderförmigen Einsatzkörpers 2 handelt, werden zum in Kontakt bringen eines Haltewerkzeuges 4, 4' verwendet, um den mit den Einsatzkörpern 2 versehenen Grundkörper 1 in einer Beschichtungskammer bei Temperaturen zwischen 1000° C und 2000° C aber auch bei höheren Temperaturen mit Siliziumkarbid zu beschichten. Die Haltewerkzeuge 4, 4' greifen an den freien Oberflächen der Einsatzkörper 2 an, um entweder das zu beschichtende Bauteil lediglich stützend zu untergreifen (siehe Figuren 5 und 6) oder um das zu beschichtende Bauteil zwischen mehreren Haltewerkzeugen 4, 4' einzuspannen (siehe Figuren 1, 2 und 3, 4).

Die Haltewerkzeuge 4, 4' greifen nur im Zentralbereich der freien Oberfläche des Einsatzkörpers 2 an, also an einer vom Rand des Einsatzkörpers 2 entfernten Stelle. Bei dem Beschichtungsprozess werden somit sämtliche freien Oberflächenabschnitte des Grundkörpers 1 unterbrechungsfrei mit einer Beschichtung, im Ausführungsbeispiel mit einer SiC-Beschichtung beschichtet. Die Beschichtung setzt sich fort bis zu den Flächenabschnitten der freien Oberflächen der Einsatzkörper 2, an denen die Haltewerkzeuge 4, 4' berührend angreifen. Die Ränder der Einsatzkörper 2 werden somit mit einer Beschichtung überwachsen. Da die Beschichtung und die Einsatzkörper 2 materialidentisch sind, müssen die Kontaktstellen der Haltewerkzeuge 4, 4' an den freien Oberflächen der Einsatzkörper 2 nicht in einem weiteren Beschichtungsschritt beschichtet werden. Die Beschichtung des Bauteiles ist somit in einem einzigen Beschichtungsprozess durchführbar. Es erfordert kein Umspannen.

Bei dem in den Figuren 1 und 2 dargestellten ersten Ausführungsbeispiel besitzt der kreisscheibenförmige Grundkörper auf seiner Oberseite eine Vielzahl von Taschen 5, jeweils zur Aufnahme eines Substrates, welches in einer CVD-Vorrichtung beschichtet werden soll. Die Rückseite ist glattwandig und wird bei der Verwendung des Bauteiles als Suszeptor aufgeheizt.

Der Grundkörper 1 besitzt eine Mittelachse 6 und eine durch die Mittelachse 6 hindurchgehende Bohrung, die eine Ausnehmung 3 ausbildet, in der ein Einsatzkörper 2 steckt. Der Einsatzkörper 2 kann reibschlüssig in der Ausnehmung 3 gehalten sein. Er kann aber auch durch ein Gewinde oder dergleichen formschlüssig in der Ausnehmung 3 gehalten sein. Denkbar ist auch die Verwendung von Flüssigkeramik oder andere Mittel, um den Einsatzkörper 2 in der Ausnehmung 3 zu halten. Der zylinderförmige Einsatzkörper 2 besitzt eine Achslänge, die der Materialstärke des Grundkörpers 1 entspricht, sodass die beiden Stirnseiten des Einsatzkörpers 2 bündig in die Oberseite bzw. Unterseite des Grundkörpers 1 übergehen.

An den beiden voneinander weg weisenden Stirnseiten des Einsatzkörpers 2, die nach außen frei liegen, können beim Beschichten Haltewerkzeuge 4, 4' angreifen, die den Einsatzkörper 2 bzw. den daran befestigten Grundkörper 1 zwischen sich einspannen.

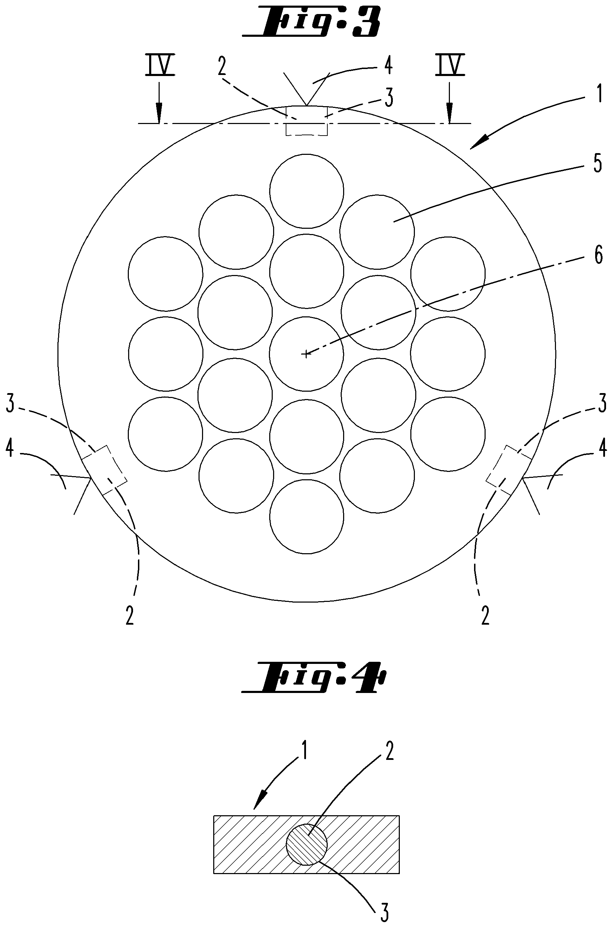

Bei dem in den Figuren 3 und 4 dargestellten zweiten Ausführungsbeispiel besitzt das Bauteil ebenfalls eine Kreiszylinderform. Es handelt sich um einen scheibenförmigen Suszeptor. Der Grundkörper 1 besitzt in seiner Zylindermantelwand 3 Sackbohrungen, die Ausnehmungen 3 ausbilden, in den jeweils ein Einsatzkörper 2 steckt. Die Einsatzkörper 2 können auch hier eine Zylinderform aufweisen und den Sackbohrungen formangepasst sein. Die Stirnseiten der Einsatzkörper 2 liegen in der Zylindermantelwand. Es sind insgesamt drei Einsatzkörper 2 um 120 Grad winkelversetzt angeordnet.

Bei dem in den Figuren 5 und 6 dargestellten Ausführungsbeispiel stecken drei Einsatzkörper 2 ebenfalls in Sackbohrungen. Die Sackbohrungen befinden sich auf der Unterseite eines scheibenförmigen Suszeptors und auf einer Kreisbogenlinie 7, die um das Zentrum 6 des Grundkörpers 1 verläuft. Auch hier sind die Ausnehmungen 3 um 120 Grad winkelversetzt angeordnet. Anders als bei den zuvor beschriebenen Ausführungsbeispielen liegen hier die freien Oberflächenabschnitte in einer gemeinsamen Ebene, nämlich der Rückseitenebene des Grundkörpers 1.

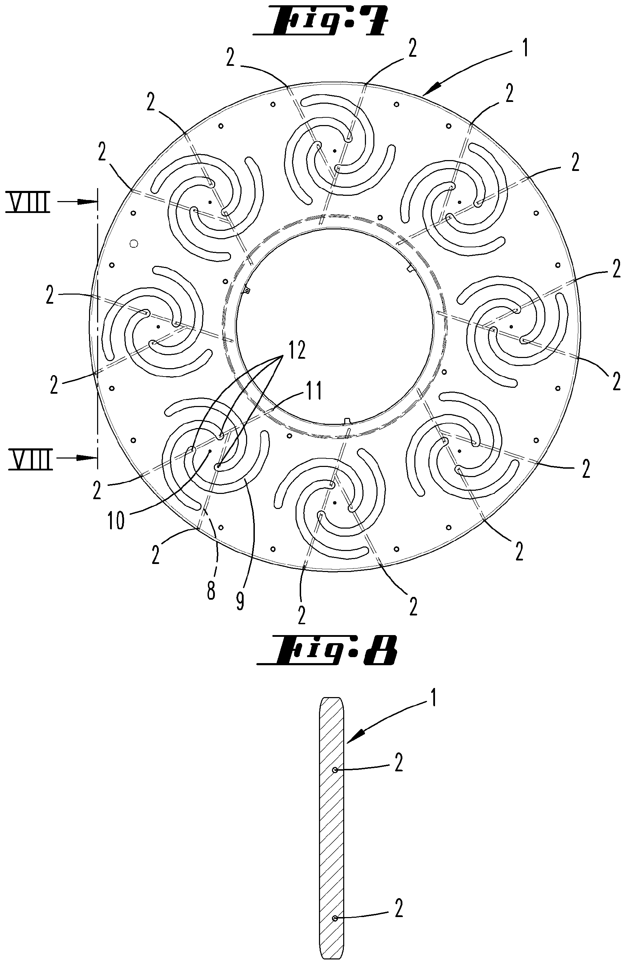

Die Figuren 7 und 8 zeigen ein weiteres Ausführungsbeispiel. Gezeigt ist dort ein Suszeptor 1 eines CVD-Reaktors. Der Suszeptor ist ein Ringkörper und besitzt acht Lagerplätze für jeweils einen kreisscheibenförmigen, nicht dargestellten Substratträger. Unterhalb jedes Substratträgers befindet sich eine Anordnung aus vier spiralförmigen Nuten, in die durch am Radialinnenende der Nuten angeordnete Einspeiseöffnungen ein Gas austreten kann. Dieses Gas bildet ein Gaskissen aus, welches zufolge der spiralförmigen Nuten 9 eine Drehrichtung besitzt. Der um einen in einer Zentrieröffnung 10 steckenden Zentrierstift drehbare Substratträger wird dadurch vom Gaskissen getragen und drehangetrieben.

Um die Gasaustrittsöffnungen 12 mit Gas zu versorgen, sind Bohrungen 8 vorgesehen. Diese Bohrungen bilden Gaseinspeisekanäle. Sie werden als Sackbohrungen gefertigt und gehen von der Außenmantelwand des Suszeptors 1 aus. Die Gasaustrittsöffnung 12 wird von einer Querbohrung ausgebildet. Am radial inneren Ende der Sackbohrung 8 befindet sich eine nach unten offene Einspeiseöffnung 11. Durch diese Einspeiseöffnung 11 wird das besagte Gas in den Kanal 8 eingespeist. Sämtliche Kanäle sind mit Stopfen 2 aus Siliciumcarbid oder einem anderen oben genannten Werkstoff verschlossen. Diese Stopfen bilden jeweils Einsatzkörper 2 aus, die beim Beschichten des Suszeptors 1 als Spannstellen verwendet werden können, um an den Stellen den Suszeptor 1 zu haltern.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:
Ein Bauteil, das dadurch gekennzeichnet ist, dass in mindestens einer Ausnehmung 3 des Grundkörpers 1 ein Einsatz 2 aus dem zweiten Werkstoff steht, der einen freien Oberflächenabschnitt aufweist zum in Kontakt bringen eines Haltewerkzeuges 4, 4', mit dem das Bauteil während des Beschichtens gehalten wird;
Ein Verfahren, das dadurch gekennzeichnet ist, dass ein Grundkörper 1 verwendet wird, bei dem in mindestens einer Ausnehmung 3 ein Einsatz 2 aus dem zweiten Werkstoff steckt, der eine freie Oberfläche aufweist, an der das Haltewerkzeug 4, 4' in Kontakt tritt, um das Bauteil während des Beschichtens zu halten;
Ein Bauteil oder Verfahren, das dadurch gekennzeichnet ist, dass das Bauteil, insbesondere der Suszeptor, einen kreisförmigen Grundriss aufweist und der Einsatz 2 in einer durch die Zentrumsachse des Bauteils gehenden, sowohl zur Oberseite des Bauteils als auch zur Unterseite des Bauteils offenen Ausnehmung 3 steckt, wobei der Einsatz 2 insbesondere die Form eines Kreiszylinders aufweist;
Ein Bauteil oder Verfahren, das dadurch gekennzeichnet ist, dass mehrere Einsätze 2 in voneinander verschiedenen Stellen angeordneten Ausnehmungen 3 stecken, wobei insbesondere vorgesehen ist, dass bei einem Bauteil mit kreisförmigem Grundriss 3 Einsätze 2 in jeweils einer Ausnehmung 3 stecken und die Ausnehmungen als Sackbohrungen ausgebildet sind;
Eine Bauteil oder Verfahren, das dadurch gekennzeichnet ist, dass die Einsätze 2 reibschlüssig oder formschlüssig in den Ausnehmungen 3 gehalten sind;
Eine Bauteil oder Verfahren, das dadurch gekennzeichnet ist, dass das Bauteil aus Graphit oder Molybdän besteht und die Beschichtung sowie der Werkstoff des Einsatzes 2 Siliziumkarbid oder ein anderes Metallkarbid ist;
Ein Bauteil oder Verfahren, das dadurch gekennzeichnet ist, dass die Ränder der freien Oberfläche des Einsatzes 2, die an die Oberfläche des Grundkörpers 1 angrenzen mitbeschichtet sind;
Ein Verfahren, das dadurch gekennzeichnet ist, dass die Haltewerkzeuge 4, 4' an einer vom Rand des Einsatzes 2, mit dem die freie Oberfläche des Einsatzes 2 an die Oberfläche des Grundkörpers 1 angrenzt, entfernten Stelle an der freien Oberfläche angreifen, sodass der Rand beim Beschichten von der Beschichtung übergriffen wird;
Ein Verfahren, das dadurch gekennzeichnet ist, dass die Beschichtung im Vakuum oder unter Niedrigdruckbedingungen durchgeführt wird;
Ein Bauteil oder Verfahren, das dadurch gekennzeichnet ist, dass der Grundkörper 1 eine Zylinderform aufweist und die Ausnehmungen 3, in denen jeweils ein Einsatz 2 steckt, in der Zylindermantelfläche insbesondere in gleichmäßiger Winkelverteilung angeordnet sind.

Ein Bauteil oder Verfahren, welches dadurch gekennzeichnet ist, dass der Einsatzkörper 2 eine Öffnung eines Einspeisekanals 8 verschließt, wobei der Einspeisekanal 8 insbesondere von einer durch den Einsatzkörper 2 verschlossenen Sackbohrung ausgebildet ist, in welche Querbohrungen 11, 12 münden.

### Bezugszeichenliste

- 1: Grundkörper
- 2: Einsatzkörper
- 3: Ausnehmung
- 4: Haltewerkzeug
- 4': Haltewerkzeug
- 5: Taschen
- 6: Mittelpunktachse
- 7: Kreisbogenlinie
- 8: Einspeisekanal
- 9: Nuten
- 10: Zentrierbohrung
- 11: Querbohrung
- 12: Querbohrung

## Patentansprüche

1. Verfahren zum Beschichten eines Bauteiles, wobei ein Grundkörper (1), der aus einem ersten Werkstoff gefertigt ist, an mindestens einer Stelle mit einem Haltewerkzeug (4, 4') gehalten wird und mit einem zweiten Werkstoff, der vom ersten Werkstoff verschieden ist, beschichtet wird, **dadurch gekennzeichnet, dass** ein Grundkörper (1) verwendet wird, bei dem in mindestens einer Ausnehmung (3) ein Einsatz (2) aus dem zweiten Werkstoff steckt, der eine freie Oberfläche aufweist, an der das Haltewerkzeug (4, 4') das Bauteil während des Beschichtens durch eine berührende Anlage hält.

2. Nach dem Verfahren gemäß Anspruch 1 gefertigtes Bauteil mit einem Grundkörper (1), der aus einem ersten Werkstoff gefertigt ist und mit einem zweiten Werkstoff beschichtet ist, wobei der erste Werkstoff verschieden vom zweiten Werkstoff ist, **dadurch gekennzeichnet, dass** in mindestens einer Ausnehmung (3) des Grundkörpers (1) ein Einsatz (2) aus dem zweiten Werkstoff reibschlüssig oder formschlüssig gehalten ist, der einen freien Oberflächenabschnitt aufweist, an welchen die Beschichtung angrenzt.

3. Bauteil nach Anspruch 2 oder Verfahren nach Anspruch 1, **dadurch gekennzeichnet, dass** das Bauteil einen kreisförmigen Grundriss aufweist und der Einsatz (2) in einer durch die Zentrumsachse des Bauteils gehenden, sowohl zur Oberseite des Bauteils als auch zur Unterseite des Bauteils offenen Ausnehmung (3) steckt, wobei der Einsatz (2) die Form eines Kreiszylinders aufweist.

4. Bauteil nach Anspruch 2 oder Verfahren nach Anspruch 1, **dadurch gekennzeichnet, dass** mehrere Einsätze (2) in voneinander verschiedenen Stellen angeordneten Ausnehmungen (3) stecken, wobei insbesondere vorgesehen ist, dass bei einem Bauteil mit kreisförmigem Grundriss (3) Einsätze (2) in jeweils einer Ausnehmung (3) stecken und die Ausnehmungen als Sackbohrungen ausgebildet sind.

5. Bauteil nach einem der vorhergehenden Ansprüche oder Verfahren nach einem der vorhergehenden Ansprüche, **dadurch gekennzeichnet, dass** das Bauteil aus Graphit oder Molybdän besteht und die Beschichtung sowie der Werkstoff des Einsatzes (2) Siliziumkarbid oder ein anderes Metallkarbid ist.

6. Bauteil nach einem der vorhergehenden Ansprüche, **dadurch gekennzeichnet, dass** die Ränder der freien Oberfläche des Einsatzes (2), die an die Oberfläche des Grundkörpers (1) angrenzen mitbeschichtet sind.

7. Verfahren nach einem der vorhergehenden Ansprüche, **dadurch gekennzeichnet, dass** die Haltewerkzeuge (4, 4') an einer vom Rand des Einsatzes (2), mit dem die freie Oberfläche des Einsatzes (2) an die Oberfläche des Grundkörpers (1) angrenzt, entfernten Stelle an der freien Oberfläche angreifen, sodass der Rand beim Beschichten von der Beschichtung übergriffen wird.

8. Verfahren nach einem der vorhergehenden Ansprüche, **dadurch gekennzeichnet, dass** die Beschichtung im Vakuum oder unter Niedrigdruckbedingungen durchgeführt wird.

9. Bauteil oder Verfahren nach einem der vorhergehenden Ansprüche, **dadurch gekennzeichnet, dass** der Grundkörper (1) eine Zylinderform aufweist und mehrere Ausnehmungen (3), in denen jeweils ein Einsatz (2) steckt, in der Zylindermantelfläche in gleichmäßiger Winkelverteilung angeordnet sind.

10. Bauteil oder Verfahren nach einem der vorhergehenden Ansprüche, **dadurch gekennzeichnet, dass** der Einsatzkörper (2) eine Öffnung eines Einspeisekanals (8) verschließt, wobei der Einspeisekanal (8) von einer durch den Einsatzkörper (2) verschlossenen Sackbohrung ausgebildet ist, in welche Querbohrungen (11, 12) münden.

11. Bauteil oder Verfahren nach einem der vorhergehenden Ansprüche, **dadurch gekennzeichnet, dass** das Bauteil ein Suszeptor eines CVD-Reaktors ist.

## Claims

1. Method for coating a component, a main body (1) made of a first material being held at at least one point by means of a holding tool (4, 4') and coated with a second material, which is different from the first material, **characterised in that** a main body (1) is used in which an insert (2) consisting of the second material is inserted in at least one recess (3) and comprises a free surface on which the holding tool (4, 4') holds the component during the coating by means of contacting abutment.

2. Component produced according to the method according to claim 1, comprising a main body (1) which is made of a first material and coated with a second material, the first material being different from the second material, **characterised in that** an insert (2) consisting of the second material is held in at least one recess (3) in the main body (1) by means of friction or in a form-fitting manner and comprises a free surface portion adjacent to the coating.

3. Component according to claim 2 or method according to claim 1, **characterised in that** the component has a circular design and the insert (2) is inserted in a recess (3) that extends through the central axis of the component and is open both towards the upper face of the component and towards the lower face of the component, the insert (2) being in the shape of a circular cylinder.

4. Component according to claim 2 or method according to claim 1, **characterised in that** a plurality of inserts (2) are inserted in recesses (3) arranged at different positions from one another, it being provided in particular in a component having a circular design (3) for inserts (2) to be inserted in one recess (3) in each case and for the recesses to be designed as blind holes.

5. Component according to any of the preceding claims or method according to any of the preceding claims, **characterised in that** the component consists of graphite or molybdenum and the coating and the material of the insert (2) is silicon carbide or another metal carbide.

6. Component according to any of the preceding claims, **characterised in that** the edges of the free surface of the insert (2) which adjoin the surface of the main body (1) are coated as well.

7. Method according to any of the preceding claims, **characterised in that** the holding tools (4, 4') act upon the free surface at a point remote from the edge of the insert (2) at which the free surface of the insert (2) adjoins the surface of the main body (1), such that the edge is covered by the coating during the coating.

8. Method according to any of the preceding claims, **characterised in that** the coating is carried out in a vacuum or in low-pressure conditions.

9. Component or method according to any of the preceding claims, **characterised in that** the main body (1) has a cylindrical shape, and a plurality of recesses (3), in each of which an insert (2) is inserted, are arranged in the cylinder lateral surface in the same angular distribution.

10. Component or method according to any of the preceding claims, **characterised in that** the insert body (2) closes an opening of a feeding channel (8), the feeding channel (8) being formed by a blind hole which is closed by the insert body (2) and into which transverse bores (11, 12) lead.

11. Component or method according to any of the preceding claims, **characterised in that** the component is a susceptor of a CVD reactor.

## Revendications

1. Procédé de revêtement d'un composant, dans lequel un corps de base (1) fabriqué à partir d'un premier matériau est maintenu en au moins un endroit par un outil de maintien (4, 4') et est revêtu d'un deuxième matériau différent du premier matériau, **caractérisé en ce que** l'on utilise un corps de base (1) ayant, inséré dans au moins un évidement (3), un insert (2) fait du deuxième matériau qui présente une surface libre par laquelle l'outil de maintien (4, 4') maintient par contact le composant pendant le revêtement.

2. Composant fabriqué selon le procédé selon la revendication 1, comprenant un corps de base (1) qui est fabriqué à partir d'un premier matériau et est revêtu d'un deuxième matériau, le premier matériau étant différent du deuxième matériau, **caractérisé en ce qu'**un insert (2) fait du deuxième matériau est maintenu par friction ou par verrouillage de forme dans au moins un évidement (3) du corps de base (1), lequel insert présente une section de surface libre que jouxte le revêtement.

3. Composant selon la revendication 2 ou procédé selon la revendication 1, **caractérisé en ce que** le composant présente un plan de base circulaire et **en ce que** l'insert (2) est inséré dans un évidement (3) passant par l'axe central du composant et qui est ouvert aussi bien sur le haut du composant que sur le bas du composant, dans lequel l'insert (2) a la forme d'un cylindre circulaire.

4. Composant selon la revendication 2 ou procédé selon la revendication 1, **caractérisé en ce que** plusieurs inserts (2) sont insérés dans des évidements (3) disposés à des endroits différents les uns des autres, dans lequel est prévu en particulier que, dans le cas d'un composant avec un plan de base circulaire (3), des inserts (2) sont insérés chacun dans un évidement (3) et les évidements sont réalisés en tant que trous borgnes.

5. Composant selon l'une quelconque des revendications précédentes ou procédé selon l'une quelconque des revendications précédentes, **caractérisé en ce que** le composant est fait de graphite ou de molybdène, et le revêtement, ainsi que le matériau de l'insert (2) sont du carbure de silicium ou un autre carbure métallique.

6. Composant selon l'une des revendications précédentes, **caractérisé en ce que** les bords de la surface libre de l'insert (2) qui jouxtent la surface du corps de base (1) sont également revêtus.

7. Procédé selon l'une des revendications précédentes, **caractérisé en ce que** les outils de maintien (4, 4') engagent un endroit de la surface libre éloigné du bord de l'insert (2) avec lequel la surface libre de l'insert (2) jouxte la surface du corps de base (1), de manière que le bord soit recouvert par le revêtement pendant le revêtement.

8. Procédé selon l'une des revendications précédentes, **caractérisé en ce que** le revêtement est réalisé sous vide ou sous basse pression.

9. Composant ou procédé selon l'une des revendications précédentes, **caractérisé en ce que** le corps de base (1) a une forme cylindrique et plusieurs évidements (3), dans chacun desquels est inséré un insert (2), sont disposés dans la surface du cylindre avec une répartition angulaire régulière.

10. Composant ou procédé selon l'une des revendications précédentes, **caractérisé en ce que** le corps d'insertion (2) ferme une ouverture d'un canal d'alimentation (8), dans lequel le canal d'alimentation (8) est formé par un trou borgne qui est fermé par le corps d'insertion (2) et dans lequel débouchent des perçages/alésages transversaux (11, 12).

11. Composant ou procédé selon l'une quelconque des revendications précédentes, **caractérisé en ce que** le composant est un suscepteur d'un réacteur CVD.
